# EUROPEAN PATENT APPLICATION

(11) **EP 1 187 201 A1**
(43) Date of publication of application: **13.03.2002**
(21) Application number: 00830602.9
(22) Date of filing: 06.09.2000
(51) Int. Cl.: H01L 23/495, H01L 21/56

(54) **Multiple-chip module**

(71) Applicant: STMicroelectronics S.r.l., 20041 Agrate Brianza (Milano) (IT)
(72) Inventor: Motta, Valter, 23877 Paderno D'Adda, LC (IT); Frezza, Giovanni, 20097 San Donato Milanese, MI (IT)
(74) Representative: Mittler, Enrico

(57) **Abstract**

The present invention relates to a multiple-chip module comprising a package cavity (6) and a lead frame (26). The multiple-chip module has said lead frame (26) divided into die pad multiple islands (23, 24) and each of said die pad multiple islands (23; 24) is placed at different values of depression with respect to the plane (5) of said lead frame (26), so as to guarantee a perfect balanced resin's flow (27) in each part of said package cavity (6).

## Description

The present invention relates to a multiple-chip module, particularly for MEMS (Micro ElectroMechanical Systems) assembling.

In a molding process of a semiconductor device or of an integrated circuit, this last is welded on a metallic structure called lead frame, and it has thin reeds or wires, made by gold or copper or aluminum or by another conductive material, to ensure the wire connection.

In a successive step, a mold is enveloped round the top and low surface of the integrated circuit of the lead frame and said mold is filled, by injection means, with plastic or resinous material, in order to obtain an enclosure body, the so called package, of the integrated circuit.

The lead frame design, therefore, is fundamental in the packaging process of the die bonding, wire connection and molding.

Because of the miniature size of semiconductor devices and due to the need of a very large die pad area to allocate multiple chips or dices, the lead frame design becomes critical.

In fact the die pad area must be big enough to ensure a stable process of the die bonding and wire connection and it must ensure that the plastic or resinous material fills completely the package cavity.

In the prior art the resin flow doesn't guarantee a complete filling of the cavity package and in this way the problems of voids, entrapped air and imperfect adhesion of the molding compound to the internal structures can't be avoided, causing an intrinsic fragility of the semiconductor device.

The state of the art consists in a die pad down set optimized in function of the thickness of the dice.

The Applicant perceives that in the case of a MEMS assembling where there is the possibility that one die or chip is thicker than the others, the resin flow is turbulent or unbalanced.

Moreover the Applicant perceives that the packaging process for a multi-chip module in MEMS applications necessitates a very tight control of the molding process parameters, of the die thickness and of the lead frame down set.

Moreover the Applicant perceives that the process parameters strongly depend on any minimum dimensional change.

Moreover the Applicant perceives that the packaging process requires a dedicated and expensive molding compound, that is the resin compound must have a tight viscosity curve, that is the viscosity curve has variables that can change in a small range.

Moreover the Applicant perceives that a die thickness variation has a relevant impact on the wafer fabrication as well as on the slicing process.

Therefore the lead frame design is critical for the size, the position and the geometry of the die pad.

In view of the state of the art described, it is an object of the present invention to have a balanced resin flow in each part of the package cavity.

It is also an object of the present invention to have a more robust package.

According to the present invention, such objects are achieved by a multiple-chip module comprising a package cavity and a lead frame, characterized in that said lead frame is divided into die pad multiple islands and each of said die pad multiple islands is placed at different values of depression with respect to the plane of said lead frame, so as to guarantee a perfectly balanced resin flow in each part of said package cavity.

Thanks to the present invention is possible to make a very stable process.

Moreover the resin flow, in this way, can easily be balanced in function of the die thickness or the transistor height, so that the flow is uniform along the die pad area.

Moreover it is also possible to make a void and delamination free process.

Moreover it is also possible to make a packaging process without any consequence on the other steps of the process.

Moreover it is also possible to have a wider opportunity of material selection, so that molding or resin compound have a viscosity curve with parameters that can change in wider ranges.

Moreover it is also possible to make electrically insulated die pads.

The features and the advantages of the present invention will be made evident by the following detailed description of an embodiment thereof which is illustrated as not limiting example in the annexed drawings, wherein:
Figures from 1 to 6 show a resin flow according to the prior art;
Figures from 7 to 11 show a resin flow according to the present invention;
Figure 12 shows a first embodiment of a multiple die pad down set according to the present invention;
Figure 13 shows a section 13-13 of Figure 12;
Figure 14 shows a second embodiment of a multiple die pad down set according to the present invention;
Figure 15 shows a section 15-15 of Figure 14;
Figure 16 shows a third embodiment of a multiple die pad down set according to the present invention;
Figure 17 shows a section 17-17 of Figure 16.

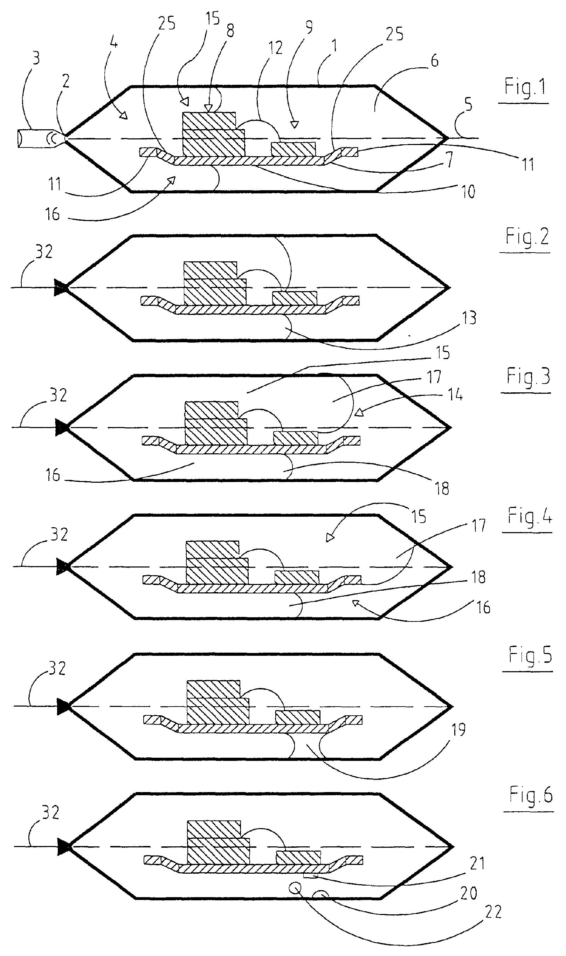

In Figures 1 to 6 a resin flow according to the prior art is shown.

We note, for all said Figures, a package 1 that has an inlet hole 2, called "gate", for an injection mean 3 of a plastic or resinous material 4.

Said injection mean 3 is placed on a plane 5 of a structure 7, called lead frame, in order to obtain a complete filling of the package cavity 6.

We note also that the lead frame 7 is realized in a such a way that a central portion 10 is at a lower level with respect to the extremities 11.

The central part 10 is linked to its extremities 11 and to a main lead frame (not shown in Figure) by a plurality of tie bars 25.

The lead frame 7 also supports two different semiconductor devices one of which is a sensor transistor 8 and the other is a logic transistor 9. The sensor transistor 8 is at a higher level with respect to the logic transistor 9. Moreover both transistors can be connected by a wire 12.

The central portion 10 of the lead frame 7 is the die pad area, that is an area wherein the die or the transistor are implemented.

A system comprising the die pad area 10 plus the sensor and logic transistors 8 and 9 realizes a MEMS assembling.

Particularly in Figure 1 we note that the resin flow is divided in two channel 15 and 16, respectively superior channel and inferior channel due to the presence of the sensor transistor 8. The velocity of the two flows is equal because the space between the package 1 and the transistor 8 and the space between the central portion 10 of the lead frame 7 and the package 1 is equal, and therefore the resin flow 4 is balanced.

A way to obtain a balanced resin flow on the sensor transistor 8 is to place said sensor transistor 8 in the center of the cavity 6, that is the down set of the lead frame 7 must be optimized for this sensor transistor 8.

Therefore the viscosity curve of the resin must be optimized also in function of the thickness of said sensor transistor 8.

Particularly in Figure 2 we note a balanced resin flow 13, having a direction like the arrow 32, inside the two channels 15 and 16, that is the velocity of the two flows between the sensor transistor 8 and the logic transistor 9 is the same.

Particularly in Figure 3 we note an unbalanced resin flow 14, having a direction like the arrow 32.

In fact this unbalance is due to the fact that the space between the package 1 and the transistor 9 and the space between the central portion 10 of the lead frame 7 and the package 1 are different and moreover the viscosity curve of the resin is defined in function of said sensor transistor 8.

This last occurrence makes, therefore, the pressure and temperature conditions of the resin 18 different in the inferior channel 16 with respect to the superior channel 15.

Due to this fact, in the superior channel 15 the resin flow 17 is faster than the flow 18 in the inferior channel 16.

Because to the different condition of the resin 18 in the inferior channel 16 said resin flow 18 polymerizes and the polymerization mechanism reduces the resin velocity.

Particularly in Figure 4 we note that the difference between the superior flow 17 and the inferior flow 18 increases and therefore the resin flow 17 begins to fill the inferior channel 16.

Particularly in Figures 5 and 6 we note that this velocity difference of the two flows 17 and 18 causes problems of entrapped air 19, of voids 20, of no good adhesion on the internal structure 21 and of unfilled package 22.

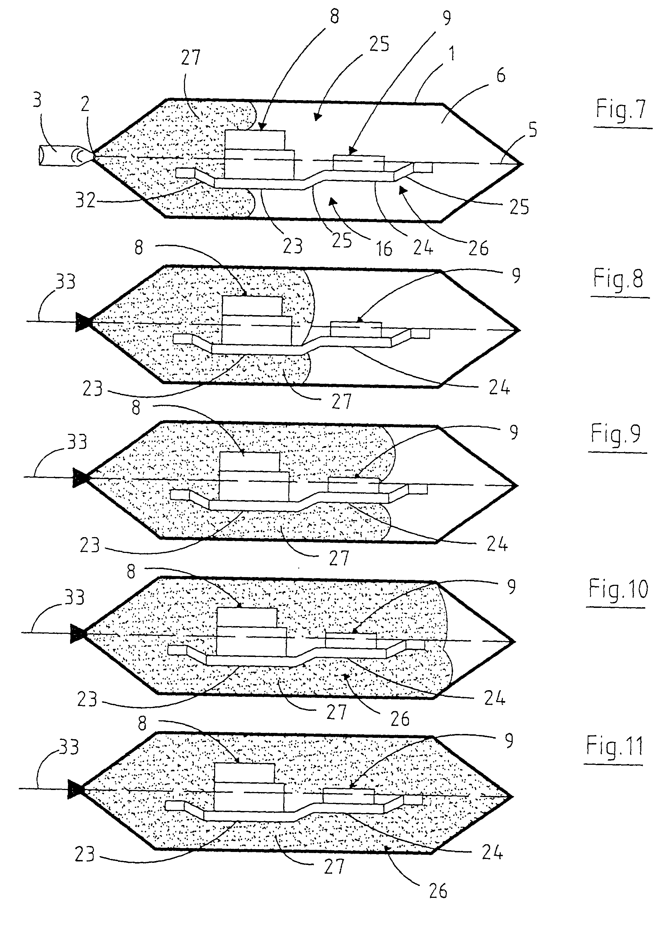

In order to ensure a perfect balanced resin's flow in each part of the package cavity, the Applicant has found an innovative solution that consist in die pad multiple islands, as shown in Figures 7 to 11.

Moreover this uniformity can be reached by adjusting the down set of the die pad, that is by centering the die pad and the wires with respect to the lead frame plane.

Therefore, in order to obtain a well balanced molding flow, the system die pad and the transistors must be perfectly centered in the package cavity.

Particularly in Figure 7 we note that the lead frame 26 is divided in two islands 23 and 24. Each island 23 (or 24) is linked to the other 24 (or 23) and to the main lead frame (not shown in Figure) through a plurality of tie bars 25 that allow different values of depression.

Moreover each island 23 (or 24) represents a die pad area, wherein the die or transistor is implemented.

Therefore we obtain that the lead frame 26 is divided in die pad area multiple islands 23 and 24.

Each island 23 (or 24) has a down set optimized for his own thickness, that is for the thickness of the sensor transistor 8 and of the logic transistor 9.

In this way each single part, that is the die pad islands 23 and 24 and the tie bars 25 of the lead frame system 26 plus the sensor and logic transistors 8 and 9, can be well positioned and balanced in the package cavity 6, with respect to the plane of said lead frame 26.

Moreover we can note that the resin flow 27 is balanced on the sensor transistor 8, because the down set of the lead frame 26, specifically of die pad area 23, is optimized for this sensor transistor 8.

Particularly in Figure 8 we note that the innovative lead frame 26 produces a balanced resin flow 27, having a direction like the arrow 33, in the superior and inferior channels 15 and 16, avoiding all molding process problems, such as voids, entrapped air, unbalanced resin flow and delaminations.

In fact the resin flow is balanced between the first die pad island 23 and the second die pad island 24.

Moreover we can note in Figure 9 that the resin flow 27 is balanced after the logic transistor 9, because the down set of the lead frame 26, specifically of die pad area 24, is optimized for this logic transistor 9.

We can see, also, in Figures 10 and 11 that the flows of resin have the same velocity because the lead frame 26 shows, in correspondence of the sensor transistor 8 and of the logic transistor 9, a superior and inferior channel section as equal as possible, so that the parameters that influence the viscosity curve of the resin don't suffer any change.

In this way it is possible to avoid any polymerization effect of the resin flow 27.

Moreover, in this way, the innovative lead frame 26 ensures a completely filled cavity package 6, an improvement of the Jedec level performances without any major change in the front end operations.

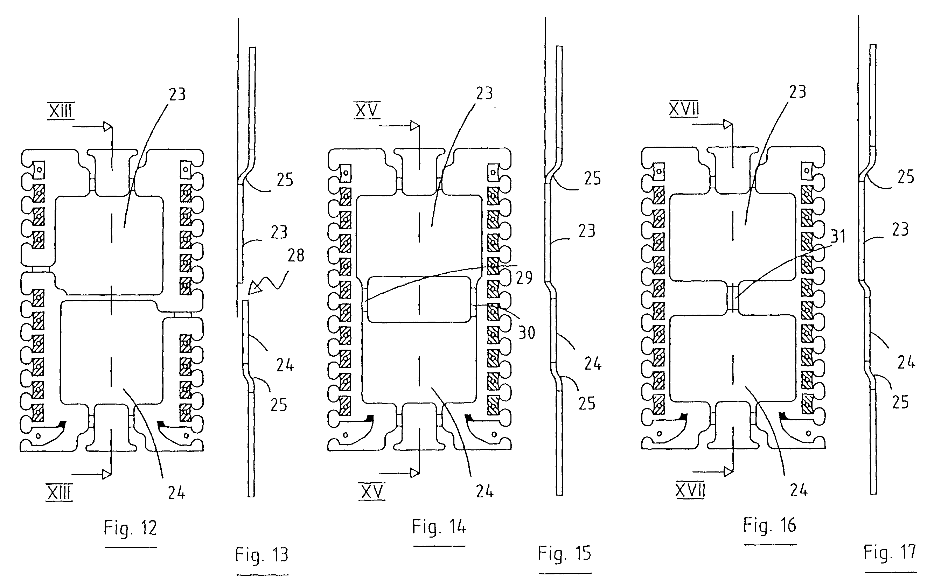

In Figure 12 a first embodiment of a multiple die pad down set according to the present invention is shown and we can note that the two die pad islands 23 and 24 are electrically insulated.

In fact, as shown in Figure 13, the two die pad islands 23 and 24 are divided by a free space 28.

In Figures 14 and 15 a second embodiment of a multiple die pad down set according to the present invention is shown and we can note that the two die pad islands 23 and 24 are linked by a double tie bar 29 and 30.

In Figures 16 and 17 a third embodiment of a multiple die pad down set according to the present invention is shown and we can note that the two die pad islands 23 and 24 are linked by one central tie bar 31.

## Claims

1. Multiple-chip module comprising a package cavity (6) and a lead frame (26), **characterized in that** said lead frame (26) is divided into die pad multiple islands (23, 24) and each of said die pad multiple islands (23; 24) is placed at different values of depression with respect to the plane (5) of said lead frame (26), so as to guarantee a perfectly balanced resin flow (27) in each part of said package cavity (6).

2. Multiple-chip module according to the claim 1, **characterized in that** said multiple island die pads (23, 24) are connected together and to said lead frame (26) by means of a plurality of tie bars (25).

3. Multiple-chip module according to the claim 1, **characterized in that** each of said multiple island die pads (23; 24) have a down set optimized for his own thickness.

4. Multiple-chip module according to the claim 1, **characterized in that** said multiple island die pads (23, 24) are connected by a double tie bar (29, 30).

5. Multiple-chip module according to the claim 1, **characterized in that** said multiple island die pads (23, 24) are connected by one central tie bar (31).

6. Multiple-chip module according to the claim 1, **characterized in that** said multiple island die pads (23, 24) are electrically insulated.
